# EUROPEAN PATENT APPLICATION

(11) **EP 3 926 352 A1**
(43) Date of publication of application: **22.12.2021**
(21) Application number: 20180036.4
(22) Date of filing: 15.06.2020
(51) Int. Cl.: G01R 31/34, G01R 33/02, H02K 1/16, H02K 7/18

(54) **MEASURING CORE LOSSES IN SEGMENTS OF ELECTRICAL MACHINES**

(71) Applicant: Siemens Gamesa Renewable Energy A/S, 7330 Brande (DK)
(72) Inventor: Djukic, Nenad, 2450 København SV (DK); Yusupov, Alisher, 7100 Vejle (DK)
(74) Representative: Aspacher, Karl-Georg

(57) **Abstract**

The present invention describes a measuring apparatus (100) for measuring losses in a circumferential segment (45) for an electrical machine. The measuring apparatus (100) comprises a frame (101) to which a circumferential segment (45) is fixable and a flux element (110, 120) attached to the frame (101) so that a circumferential segment (45) fixed to the frame (101) and the flux element (110, 120) are radially distanced and that a magnetic flux generated by a current flowing along the coil windings (44) housed in one slot (52a) of the circumferential segment (45) follows a magnetic flux path (130a, 130b, 130c, 130d) comprising at least a first path portion (130a) in one tooth (51a) circumferentially adjacent to said one slot (52a), a second path portion (130b) in the yoke(46), a third path portion (130c) in the other tooth (51b) circumferentially adjacent to said one slot (52a) and a fourth path portion (130d) in the flux element (110, 120).

## Description

### Field of the invention

The invention relates to a measuring apparatus for measuring core losses in a segment of an electrical machines, for example in a segment for a stator of an electrical generator.

### Art background

Measuring of core (iron or lamination) losses on round stator cores of electrical machines is known in the art. However, measuring core losses on the segments of electrical machines is not possible because the magnetic circuit is not closed as in round stators of electrical machines. In a segment for an electrical machine comprising a plurality of slots interposed between a plurality of teeth, the magnetic flux is created by a current flowing through the conductors wound inside the slots and around the core body and teeth. With reference to each slot, the magnetic flux has a path along a tooth on one side of the slot, along the core body below the slot bottom and along another tooth on the other side of the slot. When considering the segment alone, i.e. not assembled in an electrical machine, the air volume over the slots, radially opposite to the slot bottom, does not provide a return path for the magnetic flux. Due to such open magnetic circuit, estimating core losses in a disassembled segment is difficult.

It may be therefore desirable to provide a measuring apparatus for easily and effectively measuring core losses in a segment of an electrical machines.

### Summary of the invention

This objective may be solved by the measuring apparatus according to the independent claim. Advantageous embodiments of the present invention are described by the dependent claims.

According to the present invention a measuring apparatus is provided for measuring losses in a circumferential segment for an electrical machine.

The segment comprises:
a yoke,
a plurality of teeth radially extending from the yoke,
a plurality of slots circumferentially interposed between the plurality of teeth,
a plurality of coil windings inserted in the plurality of slots,
a frame.

In the electrical machine, a plurality of segments of the above type may be circumferentially joined to form a stator. Alternatively, a plurality of segments of the above type may be used to form a rotor.

The measuring apparatus comprises a frame to which the circumferential segment is fixable and a flux element attached to the frame so that a circumferential segment fixed to the frame and the flux element are radially distanced and that a magnetic flux generated by a current flowing along the coil windings housed in one slot of the plurality of slots follows a magnetic flux path comprising at least a first path portion in one tooth circumferentially adjacent to said one slot, a second path portion in the yoke, a third path portion in the other tooth circumferentially adjacent to said one slot and a fourth path portion in the flux element.

The present invention provides an effective and simple measuring apparatus including a return path for the magnetic flux, thus enabling low reluctance path for magnetic flux. The measured core losses are therefore meaningful and comparable with the core losses experienced in an assembled machine in operation and can be therefore used for analysis and evaluation of a real machine. This allows measuring core losses on single circumferential segments with accuracy, which permits:
discovering the flaws in segment core assembly that are made during manufacturing and before a segment is assembled into an electrical machine,
giving the possibility to better compare segments from different suppliers and give improved insight into their manufacturing processes (e.g. lamination stamping, stacking and pressing of segment laminated core, etc.),
improving prediction of iron losses in assembled electrical machine, for example generators, thus giving the possibility to further optimize generators and increase their efficiency.

In embodiments of the present invention, the flux element comprises at least one elongated element axially extending between a first axial end and a second axial end of the pluralities of slots and teeth. The flux element may comprise a measurement coil wound on the at least one elongated element for measuring a voltage induced by the magnetic flux along the fourth path portion. Such embodiments provide a bridge, axially and circumferential extending to cover one slot. The coil mounted around the bridge core, i.e. around the elongated element, permits measuring voltage induced by the flux through such bridge. In particular, the flux element may have the same circumferential extension of one slot of the said plurality of slots and two teeth of said plurality of teeth. According to specific embodiments of the present invention, the flux element comprises one central elongated element axially parallel to said one slot and two lateral elements circumferentially adjacent to the central elongated element in such a way that the central elongated element is intermediate between the two lateral elements along a circumferential direction. Advantageously, the lateral elements may be used to carry the central elongated element and adjust the airgap between the segment and the central elongated element. The central elongated element may have the same circumferential extension of one slot of the said plurality of slots and each of the two lateral elements may have the same circumferential extension of one tooth of said plurality of teeth.

According to specific embodiments of the present invention, the flux element is attached to the frame so that the the flux element is movable between a first circumferential end and a second circumferential end of the circumferential segment. Advantageously, sliding rails may be provided for sliding the bridge to different positions and measuring above different teeth and phases of a same circumferential segment. Further stiffening rails may be optionally attached to the frame for stiffening the flux element.

In other embodiments of the present invention, the flux element comprises a curved plate circumferentially extending between a first circumferential end and a second circumferential end of the circumferential segment. In such embodiments, the curved plate may be used to cover all the slots and teeth of a stator segment, thus simulating the presence of a rotor. In such embodiments, the flux element may optionally comprise a plurality of radial protrusions extending radially from the curved plate towards an axis of curvature of the curved plate the radial protrusions having a shape simulating the shape of the permanent magnets of an electrical machine. In particular, the radial protrusions may have a shape simulating the shape of the permanent magnets of the rotor of an electrical generator.

In the embodiment of the present invention, the flux element may be made of ferromagnetic material. The measuring apparatus may further comprise at least one sensor of the Hall type for performing the losses measurements. The Hall effect sensor(s) may be used together with or instead of the measurement coil wound on the elongated element of the flux element. The Hall effect sensor(s) may be provided on the elongated element, or on the circumferential segment, or in the airgap between the elongated element and the circumferential segment or be placed in other positions of the measuring apparatus.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawings

- Figure 1: shows a schematic section of a wind turbine including an electrical generator.
- Figure 2: shows an exploded view of an electrical generator with a stator having a plurality of circumferential segment.
- Figure 3: shows an axonometric view of a circumferential segment of the stator of Fig. 2.
- Figure 4: shows a first component of the segment of Fig. 3.
- Figure 5: shows a second component of the segment of Fig. 3.
- Figure 6: shows a schematic partial sectional view of a measuring apparatus according to the present invention.
- Figure 7: shows an axonometric view of a first embodiment of the measuring apparatus of Fig. 6.
- Figure 8: shows an axial view of the embodiment of Fig. 7.
- Figure 9: shows an axonometric view of a second embodiment of the measuring apparatus of Fig. 6.
- Figure 10: shows an axial view of the embodiment of Fig. 9.

### Detailed Description

The illustrations in the drawings are schematic. It is noted that in different figures, similar or identical elements are provided with the same reference signs.

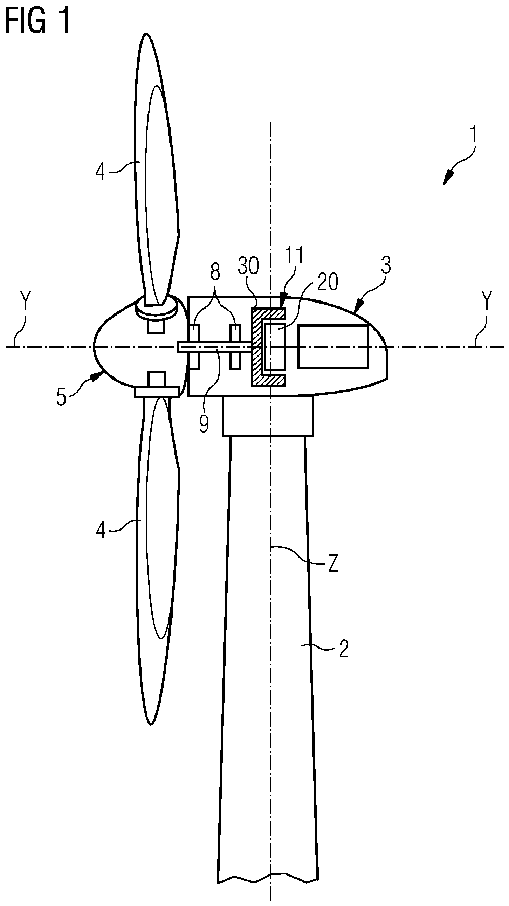

**Figure 1** shows a wind turbine 1 according to the invention. The wind turbine 1 comprises a tower 2, which is mounted on a non-depicted foundation. A nacelle 3 is arranged on top of the tower 2. The wind turbine 1 further comprises at least a wind rotor 5 having a hub and at least one blade 4 (in the embodiment of Figure 1, the wind rotor comprises three blades 4, of which only two blades 4 are visible). The wind rotor 5 is rotatable around a rotational longitudinal axis Y. The blades 4 extend substantially radially with respect to the longitudinal axis Y. In general, when not differently specified, the terms axial, radial and circumferential in the following are made with reference to the rotational longitudinal axis Y. The wind turbine 1 comprises at least one electric generator 11, including a stator 20 and a rotor 30. The rotor 30 is rotatable with respect to the stator 20 about the rotational longitudinal axis Y. The wind rotor 5 is coupled with the rotor 30 and both are connected to an outer ring of a main bearing assembly 8. The outer ring of the main bearing assembly 8 rotates about the rotational longitudinal axis Y with respect to a static inner ring, which is coupled with a main shaft 9 extending along the longitudinal axis Y.

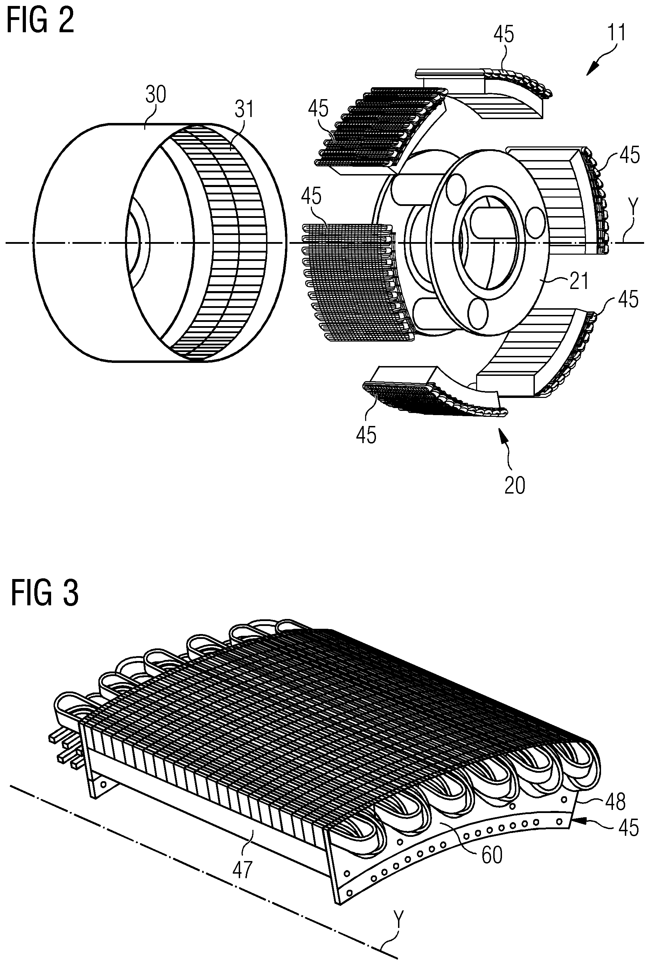

**Figure 2** shows an exploded view of the electrical generator 11 with the rotor 30 and the stator 20. The stator 20 comprises a cylindrical inner body 21 to which six circumferential segments 45 are attached. Each circumferential segment 45 has a circumferential angular extension of 60°. According to other embodiments of the present invention, the stator 20 comprises a plurality of segments having a number of segments different from six. The rotor 30 has a conventional structure with a plurality of circumferentially distributed rotor permanent magnets 31.

**Figures 3** to **5** show more in details a stator circumferential segment 45 comprising a core 60. The circumferential segment 45 axially extends between a first axial end 60a and a second axial end 60b and circumferentially extends about the longitudinal axis Y between a first circumferential end 47 and a second circumferential end 48. The core 60 may be formed through a lamination stack and may be fixed (welded or bolted) to a support structure, interposed between the lamination stack and the cylindrical inner body 21. The core 60 has a conventional structure comprising a plurality of teeth 51 circumferentially interposed between a plurality of slots 52. The teeth 51 protrude according to the radial direction from a yoke 46. The circumferential segment 45 further comprises a plurality of coil windings 44 inserted in the slots 52 of the core 60.

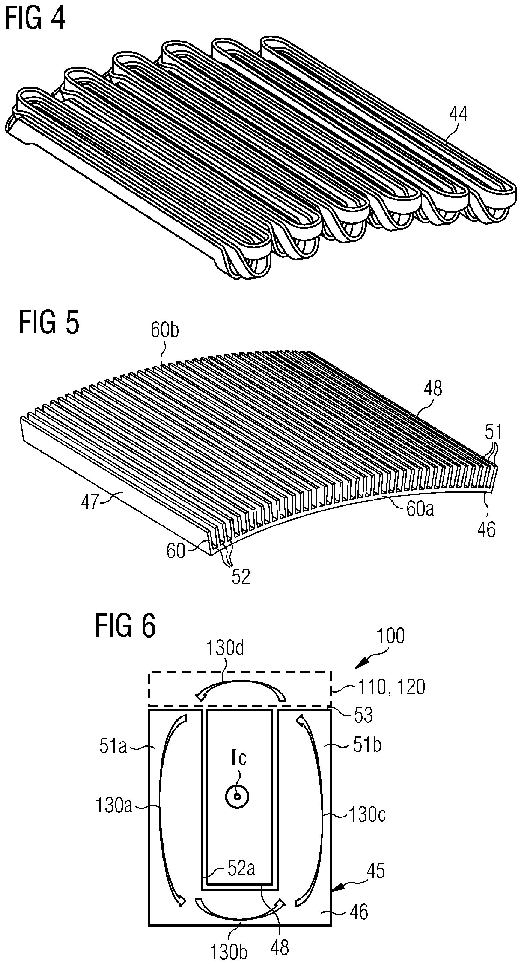

**Figure 6** shows a partial schematic view circumferential of a measuring apparatus 100 for measuring losses in a single circumferential segment 45. The measuring apparatus 100 may provide the possibility to test a circumferential segment 45 which is not connected to other circumferential segments 45 to form a stator 20. The measuring apparatus 100 comprises a flux element 110, 120 which is arranged relatively to the circumferential segment 45 in such a way that the flux element 110, 120 and the circumferential segment 45 are radially distanced from each other, a circumferential air gap 53 being radially interposed between the flux element 110, 120 and the circumferential segment 45. In the partial view of figure 6 one single slot 52a of the plurality of slots 52 is represented, which is circumferentially comprised between a first tooth 51a and a second tooth 51b. A magnetic flux generated by a current Ic flowing along the coil windings 44 housed in the slot 52a follows a magnetic flux path 130a, 130b, 130c, 130d, which comprises a first path portion 130a in the first tooth 51a, a second path portion 130b in the yoke46, a third path portion 130c in the second tooth 51b and a fourth path portion 130d in the flux element 110, 120.

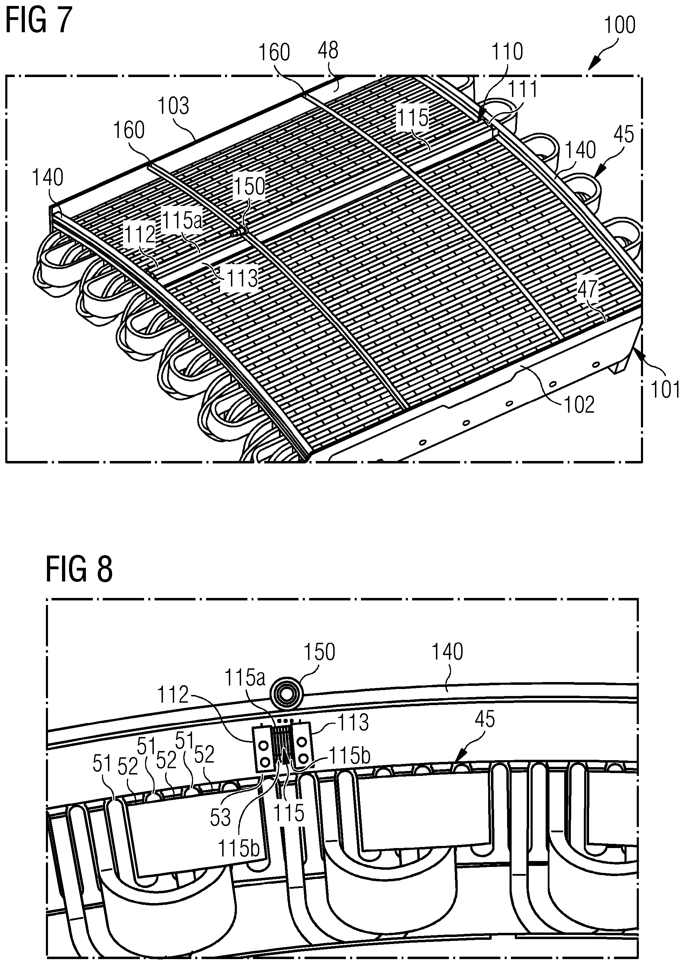

**Figures 7** to **10** show a first and a second embodiment of the measuring apparatus 100. The measuring apparatus 100 comprises a frame 101 to which the circumferential segment 45 can be fixed. The frame 101 permits attaching the the measuring apparatus 100 to the circumferential segment 45. In the embodiment of the attached figures, the frame 101 comprises two carrying side-plates 102, 103 for respectively fixing the two circumferential ends 47, 48 of the circumferential segment 45. On the two carrying side-plates 102, 103 fixing elements are provided for fixing the two circumferential ends 47, 48. Coupling elements are also provided on the frame 101 for attaching the flux element 110, 120. The frame 101 permits to define the relative position between the circumferential segment 45 and the flux element 110, 120, particularly by defining the radial extension of the air gap 53. The flux element 110, 120 comprises one elongated element 111, 121 axially extending between the first axial end 60a and the second axial end 60b of the core 60.

In the first embodiment of figures **7** and **8****,** the flux element 110 has a form of a bar attached to the frame 100 in such a way to be circumferentially moved between the two carrying side-plates 102, 103 and therefore between the first circumferential end 47 and the second circumferential end 48 of the circumferential segment 45. The flux element 110 comprises one central elongated element 111 axially parallel to one slot 52, when the central elongated element 111 is radially aligned with such slot 52. The flux element 110 further comprises two lateral elements 112, 113 circumferentially adjacent to the central elongated element 111, in such a way that the central elongated element 111 is intermediate between the two lateral elements 112, 113 along a circumferential direction. The three elongated elements are shaped as bars having respective rectangular sections. The flux element 110 comprises a measurement coil 115 wound on the central elongated element 111 for measuring a voltage induced by the magnetic flux along the fourth path portion 130d. The measurement coil 115 may be made of insulated round or rectangular wire. Number of turns of the measurement coil 115 may depend on various parameter parameters, e.g. test equipment, segment size etc., and are to be calculated for each single test. Following the shape of the central elongated element 111, the measurement coil 115 has two main sides 115a, 115b radially distanced from one another and parallel to a slot 52, when the central elongated element 111 is radially aligned with such slot 52. One main side 115b faces the air gap 53. The central elongated element 111 is supported by the lateral elements 112, 113. According to other embodiments of the present invention (not shown), the lateral elements 112, 113 are not present. The flux element 110 may have the same circumferential extension of one slot of the said plurality of slots 52 and two teeth of said plurality of teeth 51, in such a way that, when the flux element 110 is radially aligned with one slot 52, the magnetic flux path 130a, 130b, 130c, 130d is established. In the embodiment shown in figures 7 and 8, in particular, the central elongated element 111 has the same circumferential extension of one slot of the said plurality of slots 52)and each of the two lateral elements 112, 113 has the same circumferential extension of one tooth of said plurality of teeth 51. The frame 101 comprises two sliding rails 140, circumferentially connecting the two carrying side-plates 102, 103. Each sliding rail 140 is provided at a respective axial of the frame 101. The flux element 110 may comprise one or more rollers 150 sliding along each sliding rail 140 for allowing the flux element 110 to move between the first circumferential end 47 and the second circumferential end 48 of the circumferential segment 45. This permits the flux element 110 to be positioned radially above different teeth and phases of the coil windings 44, in order to perform the relevant measurements. One or more optional stiffening rails 160 (two stiffening rails 160 are shown in the embodiment of figure 7 and 8) may be provided in the frame 101 axially disposed between the two sliding rails 140 for stiffening flux element 110. Alternatively or additionally, one or more rollers 150 sliding along each stiffening rail 160 may be also provided for allowing the flux element 110 to move between the first circumferential end 47 and the second circumferential end 48 of the circumferential segment 45. The flux element 110 may include further rollers 150 sliding along the stiffening rails 160 for facilitating the flux element 110 to move between the first circumferential end 47 and the second circumferential end 48 of the circumferential segment 45.

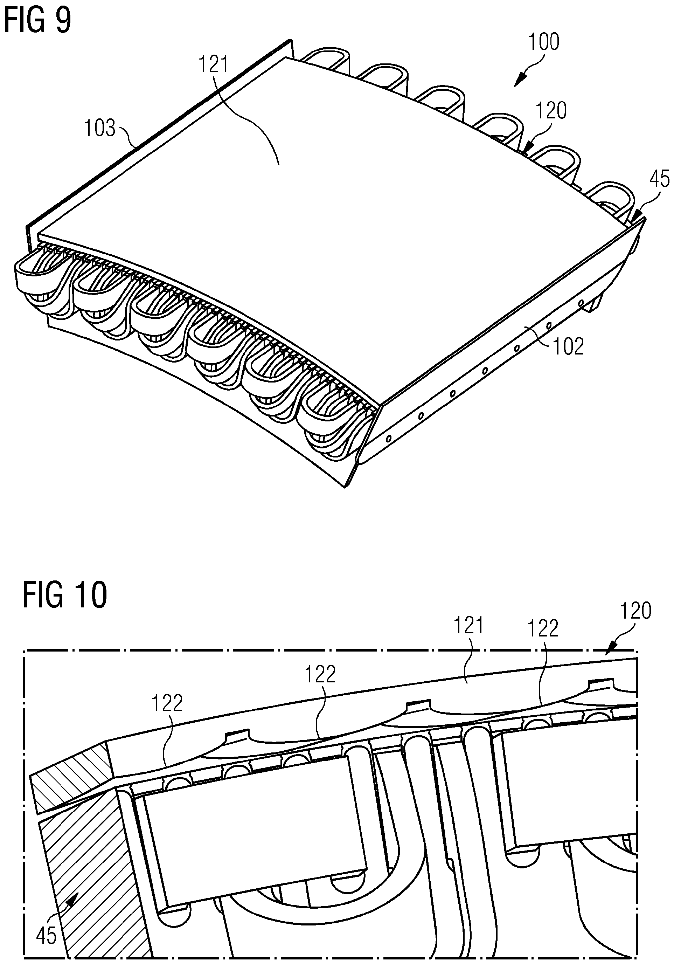

In the second alternative embodiment of figures **9** and **10****,** the flux element 120 comprises a curved plate 121 circumferentially extending between the first circumferential end 47 and a second circumferential end 48 of the circumferential segment 45. The curved plate 121 simulates a portion of the rotor 30. The flux element 120 comprises a plurality of radial protrusions 122 extending radially in the air gap 53 from the curved plate 121 towards an axis of curvature of the curved plate 121. The radial protrusions 122 simulate the rotor permanent magnets 31. The axis of curvature of the curved plate 121 may be coincident with the the longitudinal axis Y. The radial protrusions 122 simulate the shape of permanent magnets of the rotor 30. According to other embodiments of the present invention (not shown), the radial protrusions 122 are not present.

According to the different embodiments of the present invention, the flux element 110, 120 may be made of ferromagnetic material. The frame 101 and the carrying parts (i.e. the side-plates 102, 103, the sliding rails 140, the stiffening rails 160 and the rollers 150) may be made of non-magnetic material e.g. stainless steel, aluminum, epoxy composites, hard plastics etc. In particular, the flux element 110, 120 may be made of the same electrical steel from which the core 60 is made of.

According to other embodiments of the present invention (not shown), the measuring apparatus 100 may comprises at least one sensor of the Hall type. The Hall effect sensor(s) may be provided on one of the elongated elements 111, 112, 113, or on the curved plate 121, or on the circumferential segment 45, or in the air gap 53 or be placed in other positions of the measuring apparatus 100.

It should be noted that the term "comprising" does not exclude other elements or steps and "a" or "an" does not exclude a plurality. Also, elements described in association with different embodiments may be combined. It should also be noted that reference signs in the claims should not be construed as limiting the scope of the claims.

## Claims

1. A measuring apparatus (100) for measuring losses in a circumferential segment (45) for an electrical machine, the segment (45) comprising:
a yoke (46),
a plurality of teeth (51) radially extending from the yoke (46),
a plurality of slots (52) circumferentially interposed between the plurality of teeth (51),
a plurality of coil windings (44) inserted in the plurality of slots (52),
the measuring apparatus (100) comprising a frame (101) to which the circumferential segment (45) is fixable and a flux element (110, 120) attached to the frame (101) so that a circumferential segment (45) fixed to the frame (101) and the flux element (110, 120) are radially distanced and that a magnetic flux generated by a current flowing along the coil windings (44) housed in one slot (52a) of the plurality of slots (52) follows a magnetic flux path (130a, 130b, 130c, 130d) comprising at least a first path portion (130a) in one tooth (51a) circumferentially adjacent to said one slot (52a), a second path portion (130b) in the yoke(46), a third path portion (130c) in the other tooth (51b) circumferentially adjacent to said one slot (52a) and a fourth path portion (130d) in the flux element (110, 120).

2. The measuring apparatus (100) according to claim 1, wherein the flux element (110, 120) comprises at least one elongated element (111, 121) axially extending between a first axial end (60a) and a second axial end (60b) of the pluralities of slots (52) and teeth (21).

3. The measuring apparatus (100) according to claim 2, wherein the flux element (110) comprises a measurement coil (115) wound on the at least one elongated element (111) for measuring a voltage induced by the magnetic flux along the fourth path portion (130d).

4. The measuring apparatus (100) according to claim 3, wherein the measurement coil (115) has two main sides (115a, 115b) radially distanced from one another and parallel to the said one slot (52a).

5. The measuring apparatus (100) according to any of the previous claims, wherein the flux element (110) has the same circumferential extension of one slot of the said plurality of slots (52) and two teeth of said plurality of teeth (51).

6. The measuring apparatus (100) according to any of the previous claims, wherein the flux element (110) comprises one central elongated element (111) axially parallel to said one slot (52a) and two lateral elements (112, 113) circumferentially adjacent to the central elongated element (111) in such a way that the central elongated element (111) is intermediate between the two lateral elements (112, 113) along a circumferential direction.

7. The measuring apparatus (100) according to claim 6, wherein the central elongated element (111) has the same circumferential extension of one slot of the said plurality of slots (52) and each of the two lateral elements (112, 113) has the same circumferential extension of one tooth of said plurality of teeth (51).

8. The measuring apparatus (100) according to any of the previous claims, wherein the flux element (110) is attached to the frame (101) so that the the flux element (110) is movable between a first circumferential end (47) and a second circumferential end (48) of the circumferential segment (45).

9. The measuring apparatus (100) according to claim 1 or 2, wherein the flux element (120) comprises a curved plate (121) circumferentially extending between a first circumferential end (47) and a second circumferential end (48) of the circumferential segment (45).

10. The measuring apparatus (100) according to claim 9, wherein the flux element (120) comprises a plurality of radial protrusions (122) extending radially from the curved plate (121) towards an axis of curvature (Y) of the curved plate (121) the radial protrusions (122) having a shape simulating the shape of permanent magnets of an electrical machine.

11. The measuring apparatus (100) according to any of the previous claims, wherein the flux element (110, 120) is made of ferromagnetic material.

12. The measuring apparatus (100) according to any of the previous claims, wherein the measuring apparatus (100) comprises at least one sensor of the Hall type.

13. The measuring apparatus (100) according to claim 12, wherein the flux element (110, 120) comprises at least one sensor of the Hall type.
